(19) Europäisches Patentamt / European Patent Office / Office européen des brevets

(11) **EP 3 719 510 B1**

(12) **EUROPÄISCHE PATENTSCHRIFT**

(45) Veröffentlichungstag und Bekanntmachung des Hinweises auf die Patenterteilung:
**28.06.2023 Patentblatt 2023/26**

(21) Anmeldenummer: **19166489.5**

(22) Anmeldetag: **01.04.2019**

(51) Internationale Patentklassifikation (IPC):
***G01R 31/08*** *(2020.01)*

(52) Gemeinsame Patentklassifikation (CPC):
**G01R 31/088**

(54) **VERFAHREN, FEHLERORTUNGSEINRICHTUNG UND SYSTEM ZUM ERMITTELN EINES FEHLERORTES AUF EINER LEITUNG EINES ELEKTRISCHEN ENERGIEVERSORGUNGSNETZES**

METHOD, DEVICE AND SYSTEM FOR DETERMINING THE LOCATION OF A FAULT ON A LINE OF AN ELECTRICAL ENERGY SUPPLY NETWORK

PROCÉDÉ, DISPOSITIF ET SYSTÈME DE DÉTECTION D'UN EMPLACEMENT DE DÉFAILLANCE SUR UNE CONDUITE D'UN RÉSEAU D'ALIMENTATION ÉLECTRIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**07.10.2020 Patentblatt 2020/41**

(73) Patentinhaber: **Siemens Aktiengesellschaft**
**80333 München (DE)**

(72) Erfinder:
• **Dzienis, Cezary**
**14624 Dallgow-Döberitz (DE)**
• **Jurisch, Andreas**
**16727 Schwante (DE)**

(74) Vertreter: **Siemens Patent Attorneys**
**Postfach 22 16 34**
**80506 München (DE)**

(56) Entgegenhaltungen:
**EP-A1- 3 193 420     EP-A1- 3 351 949**

• **ISTRATE M ET AL: "Assessment of fault location algorithms in transmission grids", POWERTECH, 2009 IEEE BUCHAREST, IEEE, PISCATAWAY, NJ, USA, 28. Juni 2009 (2009-06-28), Seiten 1-6, XP031543071, ISBN: 978-1-4244-2234-0**

**Beschreibung**

Die Erfindung betrifft ein Verfahren zum Bestimmen eines Fehlerortes auf einer dreiphasigen Leitung eines elektrischen Wechselstrom-Energieversorgungsnetzes, bei dem an einer ersten Messstelle der Leitung erste Strommesswerte erfasst werden, die jeweilige in den Phasen der der Leitung fließende Phasenströme angeben, unter Verwendung der ersten Strommesswerte sich bei einem Fehler vom Fehlerort entlang der Leitung zur ersten Messstelle ausbreitende Wanderwellen detektiert werden, und mit einer Fehlerortungseinrichtung die detektierten Wanderwellen zur Ermittlung des Fehlerortes ausgewertet werden.

Die Erfindung betrifft auch eine Fehlerortungseinrichtung sowie ein System mit mindestens einer solchen Fehlerortungseinrichtung.

Der sichere Betrieb elektrischer Energieversorgungsnetze erfordert die schnelle und zuverlässige Erkennung und Abschaltung etwaiger Fehler, wie z.B. Kurzschlüsse oder Erdschlüsse. Fehlerursachen, die eine Abschaltung bewirken, können beispielsweise Blitzeinschläge, gerissene oder anderweitig schadhafte Leitungen, fehlerhafte Isolierungen bei Kabelleitungen oder die ungewollte Berührung von Freileitungen mit Tier- oder Pflanzenteilen sein. Zur Verkürzung von fehlerbedingten Ausfallzeiten müssen solche Fehler möglichst genau lokalisiert werden, um eine Behebung der Fehlerursache und etwaiger durch den Fehler herbeigeführter Folgeschäden durch ein Wartungsteam zu ermöglichen.

Im einfachsten, aber auch aufwendigsten, Fall findet eine Fehlerortung durch manuelle Inaugenscheinnahme statt. Dabei fährt ein Wartungsteam die fehlerhafte Leitung ab und untersucht sie auf sichtbare Fehlerstellen. Diese Vorgehensweise ist langsam und fehleranfällig.

Daher ist man weitgehend dazu übergegangen, den Fehlerort, an dem sich der Fehler auf der Leitung befindet, mittels einer Analyse von während des Fehlereintritts erfassten Messgrößen, z.B. Strömen und Spannungen, einzugrenzen. Hierfür sind mittlerweile mehrere unterschiedliche Verfahren bekannt, deren Genauigkeit sich signifikant auf den Wartungsaufwand des Energieversorgungsnetzes auswirkt. Daher wird großer Wert daraufgelegt, die Genauigkeit der für die Fehlerortung eingesetzten Algorithmen zu verbessern, um die Wartung zu erleichtern und insbesondere fehlerbedingte Ausfallzeiten des Energieversorgungsnetzes zu verkürzen.

Ein grobes Ergebnis des Fehlerortes lässt sich beispielsweise durch die Feststellung der Fehlerrichtung erreichen. Diese Methode wird überwiegend in gelöschten, isolierten sowie hochohmig geerdeten Energieversorgungsnetzen mit einer radialen Struktur bzw. einem geringen Vermaschungsgrad eingesetzt. Dabei kann beispielsweise eine wattmetrische Methode verwendet werden, wie sie aus dem Europäischen Patent EP 2476002 B1 bekannt ist. Eine andere Methode zur Erkennung der Fehlerrichtung ist das sogenannte "Wischerrelais-Prinzip", das in einer möglichen ausführungsform beispielsweise aus der internationalen Patentanmeldung WO 2012126526 A1 hervorgeht. Zur genaueren Fehlerortung ist bei diesen Methoden allerdings eine zusätzliche Auswertung nötig.

Verfahren zur genaueren Fehlerortung verwenden beispielsweise die gemessenen Strom- bzw. Spannungssignale der Grundwelle (50Hz- bzw. 60Hz-Signale) zur Fehlerortung. Hierbei sind Verfahren bekannt, die Messwerte von nur einem der Leitungsenden (einseitige Fehlerortung) oder Messwerte von beiden Leitungsenden (zweiseitige Fehlerortung) verwenden. Als Ergebnis wird der Fehlerort in der Regel als Entfernung von der jeweiligen Messstelle (in Prozent der Leitung oder in km bzw. Meilen) angegeben.

Im Fall der Verwendung von Messwerten nur eines Leitungsendes ist der Aufwand zur Durchführung der Fehlerortung gering. Bei dieser Fehlerortungsmethode handelt es sich überwiegend um eine impedanzbasierte Methode, bei der aus Strom- und Spannungsmesswerten eine Impedanz bis zum Fehlerort berechnet wird. Durch Vergleich mit der Leitungsimpedanz der gesamten Leitung im fehlerfreien Fall lässt sich ein Rückschluss auf den Fehlerort ziehen. Eine beispielhafte Ausführung eines solchen Fehlerortungsverfahrens kann beispielsweise der US-Patentschrift US 4996624 A entnommen werden.

Die Genauigkeit dieser Methode hängt unter anderem stark von der Messgenauigkeit der verwendeten Strom- und Spannungswandler, der Genauigkeit der zur Fehlerortung verwendeten Leitungsparameter (z.B. Impedanzbelag) sowie von den gegebenen Fehlerbedingungen (z.B. Fehlerwiderstand, Last) und der Netzbeschaffenheit ab. Störungen und die Einschwingvorgänge in den Strom- und Spannungssignalen können sich negativ auf die Genauigkeit dieser Methode auswirken. Die dadurch entstehenden Messfehler können mehrere Prozent betragen. Beispielsweise ergeben sich in gelöschten oder isolierten Netzen im Erdschlussfall aufgrund der großen Nullsystemimpedanzen sehr kleine Fehlerströme in Verbindung mit einem fast vollständigen Zusammenbruch der Spannung in der fehlerbehafteten Schleife. In diesem Fall führt eine Impedanzberechnung zu einer Division (Spannung geteilt durch Strom) von annähernd Null geteilt durch Null. Damit ergeben sich sehr hohe Messfehler in der Impedanzbestimmung, die eine sinnvolle Anwendbarkeit dieser Impedanzmessverfahren verhindern.

Eine verbesserte Genauigkeit bei der Fehlerortung lässt sich durch die Verwendung von Messwerten von beiden Leitungsenden erreichen. Hierbei müssen die fehlerortungsbezogenen Messwerte über eine geeignete Kommunikationsverbindung zusammengeführt werden. In diesem Zusammenhang sei auf die US-Patentschrift US 5,929,642 verwiesen; bei dem dort beschriebenen Verfahren wird unter Verwendung von Strom- und Spannungsmesswerten von beiden Leitungsenden mithilfe von Schätzverfahren und nichtlinearen Optimierungsverfahren eine recht hohe Genauigkeit (Messfehler ca. 1-2%) bei der Fehlerortung erreicht.

Während die Genauigkeit der Fehlerortung bei den impedanzbasierten Fehlerortungsverfahren von der Messgenauigkeit der verwendeten Messwandler sowie der Netzbeschaffenheit abhängt, lässt sich durch die Verwendung eines Fehlerortungsverfahrens nach dem sogenannten Wanderwellen-Prinzip ("Traveling Wave Fault Location") eine weitgehende Unabhängigkeit von diesen Größen erreichen. Nach diesem Prinzip werden anstelle der Grundwellen der gemessenen Strom- bzw. Spannungssignale die beim Fehler entstehenden transienten Signalanteile, die in Form von sogenannten "Wanderwellen" auftreten, zur Fehlerortung in Betracht gezogen. Hierbei werden die hochfrequenten Wanderwellen-Flanken messtechnisch erfasst und mit einem Zeitstempel versehen. Da die Propagationsgeschwindigkeit der Wanderwellen etwa bei der Lichtgeschwindigkeit liegt, lässt sich aus der Auswertung der Zeitstempelung die Ortung des Fehlers gut durchführen. Mit diesem Fehlerortungsverfahren können Genauigkeiten im Bereich von wenigen Dutzend Metern erreicht werden. Ein Beispiel eines solchen Fehlerortungsverfahrens kann der US-Patentschrift US 8,655,609 B2 entnommen werden.

Für die Wanderwellen-Fehlerortung wird bisher vorrangig das Prinzip der zweiseitigen Fehlerortung benutzt. Die dafür erforderliche Infrastruktur benötigt einerseits eine Kommunikationsverbindung zwischen den Messgeräten an den unterschiedlichen Messstellen und andererseits eine genaue Zeitsynchronisation der beiden Messgeräte. Alternativ kann zusätzlich zu den beiden Messgeräten im Feld eine zentrale Auswerteeinheit eingesetzt werden, die über Kommunikationsverbindungen zu beiden Messgeräten verfügt. Der damit verbundene gerätetechnische Aufwand schränkt aktuell die Attraktivität der Wanderwellen-Fehlerortung aus wirtschaftlichen Gründen auf vergleichsweise teure Hoch- und Höchstspannungsanwendungen ein.

Somit werden derartige Fehlerortungssysteme bevorzugt dort eingesetzt, wo die schnellere Wiederverfügbarkeit der fehlerbehafteten Leitung eine aufwändige Infrastruktur rechtfertigt.

Durch den Einsatz einer einseitigen Wanderwellen-Fehlerortung kann die beschriebene Hürde gesenkt werden, da in diesem Fall nur noch ein Messgerät an einer Messstelle der Leitung benötigt wird und die vorhandene Automatisierungslösung der Stationsleittechnik zur Weiterleitung der Fehlerortungsergebnisse genutzt werden kann. Aus der WO 2016/118584 A1 ist ein Verfahren zur einseitigen Wanderwellen-Fehlerortung bekannt, das auf dem Vergleich von während eines geplant herbeigeführten Fehlerereignisses erzeugten Wanderwellen mit den während eines Fehlers erzeugten Wanderwellen basiert. Hierzu werden jedoch aufwendige Vergleichsmessungen für die messtechnische Aufzeichnung der Wanderwellen bei einem geplanten Fehlerereignis erforderlich.

Aus der EP 3 351 949 A1 ist ein einseitiges Fehlerortungsverfahren bekannt, mit dem anhand gemessener Strom- und Spannungswerte unter Verwendung eines Wanderwellenausbreitungsmodells auf den Fehlerort geschlossen wird. Aus der EP 3 193 420 A1 ist schließlich ein zweiseitiges Fehlerortungsverfahren bekannt, mit dem anhand gemessener Strom- und Spannungswerte auf den Fehlerort geschlossen wird. Dabei kann ebenfalls ein Wanderwellenausbreitungsmodell verwendet werden.

Ausgehend davon liegt der Erfindung die Aufgabe zugrunde, einen Fehlerort mit der Wanderwellenmethode möglichst einfach und mit geringem messtechnischen Aufwand bestimmen zu können.

Diese Aufgabe wird erfindungsgemäß durch ein Verfahren der eingangs angegebenen Art gelöst, bei dem mit der Fehlerortungseinrichtung modale Komponenten der detektierten Wanderwelle bestimmt werden, wobei zumindest zwei der modalen Komponenten unterschiedliche Ausbreitungsgeschwindigkeiten entlang der Leitung aufweisen, und ein Abstand zwischen der ersten Messstelle und dem Fehlerort unter Verwendung derjenigen Zeitpunkte ermittelt wird, zu denen die modalen Komponenten die erste Messstelle erreichen.

Der Erfindung liegt die Erkenntnis zugrunde, dass eine einzelne Wanderwelle, die sich auf einer Leitung ausbreitet, in modale Komponenten zerlegt werden kann, die unterschiedliche Ausbreitungsgeschwindigkeiten besitzen. So breitet sich beispielsweise im Fall einer Anwendung der Clarke-Transformation die modale 0-Komponente langsamer aus als die sich mit nahezu gleicher Geschwindigkeit ausbreitenden $\alpha$- bzw. $\beta$-Komponente. Bei bekannten Ausbreitungsgeschwindigkeiten kann unter Verwendung derjenigen Zeitpunkte, zu denen die Wanderwelle in der jeweiligen modalen Komponente an der Messstelle ankommt, auf den Abstand zwischen der Messstelle und dem Fehlerort geschlossen werden. Der Zeitpunkt des Eintreffens der Wanderwelle bzw. der jeweiligen modalen Komponente der Wanderwelle kann beispielsweise mit einem Wanderwellendetektor ermittelt werden, der die Flanke der Wanderwelle erkennt. Ist der Abstand zur ersten Messstelle bekannt, kann der Fehlerort leicht ermittelt werden.

Konkret kann zur Bestimmung des Abstands zum Fehlerort vorgesehen sein, dass eine Differenz zwischen denjenigen Zeitpunkten gebildet wird, zu denen die modalen Komponenten die erste Messstelle erreichen, und der Abstand zwischen der ersten Messstelle und dem Fehlerort unter Verwendung der Differenz sowie der Ausbreitungsgeschwindigkeit der jeweiligen modalen Komponente ermittelt wird.

Beispielsweise kann der Abstand zwischen der ersten Messstelle und dem Fehlerort nach einer Messung der Empfangszeitpunkte der jeweilige modalen Komponente mit der folgenden Gleichung bestimmt werden:

$$x_{AF} = \frac{\Delta t_A \cdot v_{Komp1}}{1 - \dfrac{v_{Komp1}}{v_{Komp2}}}$$

Hierbei bedeuten:

$x_{AF}$     Abstand zwischen der ersten Messstelle und dem Fehlerort;

$\Delta t_A$     an der ersten Messstelle gemessene Zeitdifferenz zwischen den Empfangszeitpunkten der beiden modalen Komponenten der detektierten Wanderwelle;

$v_{Komp1}$     Ausbreitungsgeschwindigkeit der ersten modalen Komponente der Wanderwelle;

$v_{Komp2}$     Ausbreitungsgeschwindigkeit der zweiten modalen Komponente der Wanderwelle.

Die Ausbreitungsgeschwindigkeiten der modalen Komponenten sind im Gerät als Parameter abgespeichert und werden zur Bestimmung des Fehlerortes herangezogen.

Dabei kann beispielsweise vorgesehen sein, dass die Ausbreitungsgeschwindigkeit der jeweiligen modalen Komponente rechnerisch ermittelt wird.

Dies kann z.B. über eine Eigenwertanalyse einer Modellierung der Leitung bei bekannten Impedanz- und Admittanzmatrizen erfolgen.

Alternativ dazu kann auch vorgesehen sein, dass die Ausbreitungsgeschwindigkeit der jeweiligen modalen Komponente durch Messung ermittelt wird, indem die während eines einpoligen Schaltvorgangs auf der Leitung im fehlerfreien Zustand entstehenden Wanderwellen in modale Komponenten zerlegt und diejenigen Zeitpunkte ermittelt werden, zu denen die jeweiligen modalen Komponenten die erste Messstelle erreichen.

Hier wird quasi eine Wanderwelle für einen bekannten Ort, nämlich den Ort, an dem die Schalthandlung vorgenommen wird, erzeugt. Durch Messung der an der ersten Messstelle eintreffenden Wanderwellen und Zerlegung der Wanderwelle in ihre modalen Komponenten kann die Ausbreitungsgeschwindigkeit für jede modale Komponente ermittelt werden. Eine solche Messung kann vor Inbetriebnahme der Fehlerortungseinrichtung erfolgen.

Außerdem kann auch vorgesehen sein, dass die Messung der Ausbreitungsgeschwindigkeit der jeweiligen modalen Komponente wiederholt durchgeführt wird. Somit kann die Messung im Betrieb der Leitung bei geplanten Schalthandlungen zur Überprüfung und ggf. Anpassung der Parameter für die Ausbreitungsgeschwindigkeiten wiederholt durchgeführt werden.

Eine weitere vorteilhafte Ausführungsform des erfindungsgemäßen Verfahrens sieht vor, dass aus den jeweiligen Strommesswerten der einzelnen Phasenströme die modalen Komponenten mittels einer auf Eigenwerten basierenden Transformation zur Separierung von modalen Komponenten gebildet werden.

Dabei kann beispielsweise eine Eigenwertanalyse, die Clarke-Transformation oder die Dommel-Transformation verwendet werden. Diese Methoden ermöglichen es, aus der Wanderwelle für die drei Phasenleiter die modalen Komponenten zu ermitteln, die für die Fehlerortung benötigt werden.

Eine weitere vorteilhafte Ausführungsform des erfindungsgemäßen Verfahrens sieht zudem vor, dass die Strommesswerte mittels eines Bandpassfilters gefiltert werden, wobei der Bandpassfilter auf einen Frequenzbereich eingestellt ist, in dem die modalen Komponenten jeweils eine konstante Ausbreitungsgeschwindigkeit aufweisen.

Da die Ausbreitungsgeschwindigkeiten der modalen Komponenten frequenzabhängig sein können, kann hierdurch eine weitgehende Konstanz der Ausbreitungsgeschwindigkeit im für die Messung verwendeten Frequenzbereich erreicht werden.

Gemäß einer weiteren vorteilhaften Ausführungsform des erfindungsgemäßen Verfahrens ist vorgesehen, dass die von dem Fehlerort ausgehenden Wanderwellen auch an einer zweiten Messstelle der Leitung detektiert werden, unter Verwendung der modalen Komponenten der an der zweiten Messstelle detektierten Wanderwellen ein Abstand zwischen der zweiten Messstelle und dem Fehlerort ermittelt wird und geprüft wird, ob die Summe aus dem Abstand zwischen der ersten Messstelle und dem Fehlerort und dem Abstand zwischen der zweiten Messstelle und dem Fehlerort der Länge der Leitung zwischen den beiden Messstellen entspricht.

Hierdurch kann die Genauigkeit des Fehlerortungsverfahrens weiter erhöht werden, da die Messung von beiden Seiten durchgeführt wird. Eine zeitliche Synchronisierung der Fehlerortungseinrichtungen ist nicht erforderlich.

Außerdem kann gemäß einer weiteren vorteilhaften Ausführungsform des erfindungsgemäßen Verfahrens vorgesehen sein, dass die von dem Fehlerort ausgehenden Wanderwellen auch an einer zweiten Messstelle der Leitung detektiert werden, bei einem symmetrischen Fehler oder einem Fehler ohne Erdberührung an der ersten und der zweiten Messstelle die Zeitpunkte des Eintreffens jeweiliger Wellenfronten der jeweiligen Wanderwellen bestimmt werden, Differenzen zwischen den Zeitpunkten einerseits der zuerst eintreffenden Wellenfront und andererseits einer Mehrzahl von weiteren Wellenfronten gebildet werden, für die erste und die zweite Messstelle unter Verwendung der Differenzen eine Folge potentieller Fehlerorte gebildet wird, und

derjenige Fehlerort aus den Folgen potentieller Fehlerorte als tatsächlicher Fehlerort ausgewählt wird, für den die Summe aus dem Abstand zwischen der ersten Messstelle und dem ausgewählten Fehlerort und dem Abstand zwischen der zweiten Messstelle und dem ausgewählten Fehlerort der Länge der Leitung zwischen den beiden Messstellen entspricht.

Bei bestimmten Fehlerarten (z.B. dreiphasige symmetrische Fehler, Fehler ohne Erdberührung) kommt es nämlich nicht zur Bildung einer modalen 0-Komponente, so dass die Zerlegung in modale Komponenten nur ein unvollständiges Bild über den Fehlerort liefert. Außerdem kann es vorkommen, dass aufgrund von Reflektionen der Wanderwellen die Auswahl der zur Bestimmung des Fehlerortes geeigneten ersten Wanderwellenfront erschwert wird. Um die Fehlerortung auch unter solchen Bedingungen mit hoher Genauigkeit durchführen zu können, wird eine Auswertung auch an einer zweiten Messstelle der Leitung, üblicherweise am der ersten Messstelle abgewandten Ende der Leitung, durchgeführt. Dabei können an beiden Seiten potentielle Fehlerorte für mehrere Wanderwellenfronten bestimmt werden. Durch Vergleich der Ergebnisse für beide Enden können die beiden plausiblen Ergebnisse ausgewählt werden, nämlich diejenigen, bei denen die Summe der ermittelten Abstände zwischen der jeweiligen Messstelle und dem Fehlerort der Länge der Leitung zwischen den Messstellen entspricht.

Die oben genannte Aufgabe wird auch durch eine Fehlerortungseinrichtung zum Bestimmen eines Fehlerortes auf einer dreiphasigen Leitung eines elektrischen Energieversorgungsnetzes gelöst, wobei die Fehlerortungseinrichtung dazu eingerichtet ist, erste Strommesswerte, die jeweilige an einer ersten Messstelle in der Leitung fließende Phasenströme angeben, zu erfassen, und wobei die Fehlerortungseinrichtung dazu eingerichtet ist, unter Verwendung der ersten Strommesswerte sich bei einem Fehler vom Fehlerort entlang der Leitung zur ersten Messstelle ausbreitende Wanderwellen zu detektieren und die detektierten Wanderwellen zur Ermittlung des Fehlerortes auszuwerten.

Erfindungsgemäß ist vorgesehen, dass die Fehlerortungseinrichtung dazu eingerichtet ist, modale Komponenten der detektierten Wanderwelle zu bestimmen, wobei zumindest zwei der modalen Komponenten unterschiedliche Ausbreitungsgeschwindigkeiten entlang der Leitung aufweisen, und einen Abstand zwischen der ersten Messstelle und dem Fehlerort unter Verwendung derjenigen Zeitpunkte zu ermitteln, zu denen die modalen Komponenten die erste Messstelle erreichen.

Hinsichtlich der erfindungsgemäßen Fehlerortungseinrichtung gelten alle zu dem erfindungsgemäßen Verfahren voranstehend und nachfolgend gemachten Ausführungen und umgekehrt in entsprechender Weise, insbesondere ist die erfindungsgemäße Fehlerortungseinrichtung zur Durchführung des erfindungsgemäßen Verfahrens in jeder beliebigen Ausführungsform oder einer Kombination beliebiger Ausführungsformen eingerichtet. Auch hinsichtlich der Vorteile der erfindungsgemäßen Fehlerortungseinrichtung wird auf die zu dem erfindungsgemäßen Verfahren beschriebenen Vorteile verwiesen.

Die Fehlerortungseinrichtung kann beispielsweise in einem elektrischen Schutzgerät, das Funktionen zur Überwachung der Leitung vornimmt, integriert sein. Alternativ kann die Fehlerortungseinrichtung auch ein eigenständiges Gerät bilden. Außerdem kann auch vorgesehen sein, dass die Fehlerortungseinrichtung Bestandteil einer zentralen Komponente ist, die mit den Messwerten der zumindest der ersten Messstelle die Fehlerortung durchführt. Die zentrale Komponente kann Teil einer Leitstelle sein oder beispielsweise auch durch ein verteiltes Datenverarbeitungssystem, z.B. ein Cloudcomputingsystem gebildet werden, das die Fehlerortung als CloudService anbietet. Ein Beispiel für ein solches Cloudcomputingsystem ist die Mindsphere© der Siemens AG.

Schließlich wird die oben genannte Aufgabe auch durch ein System mit mindestens zwei solchen Fehlerortungseinrichtungen gelöst.

Erfindungsgemäß ist vorgesehen, dass das System dazu eingerichtet ist, die von dem Fehlerort ausgehenden Wanderwellen auch an einer zweiten Messstelle der Leitung zu detektieren und unter Verwendung der modalen Komponenten der an der zweiten Messstelle detektierten Wanderwellen einen Abstand zwischen der zweiten Messstelle und dem Fehlerort zu ermitteln, und dass das System dazu eingerichtet ist, zu prüfen, ob die Summe aus dem Abstand zwischen der ersten Messstelle und dem Fehlerort und dem Abstand zwischen der zweiten Messstelle 21b und dem Fehlerort der Länge der Leitung zwischen den beiden Messstellen entspricht.

Mit einem solchen System kann eine sehr genaue Fehlerortung durchgeführt werden.

Alternativ kann bezüglich des Systems erfindungsgemäß vorgesehen sein, dass das System dazu eingerichtet ist, die von dem Fehlerort ausgehenden Wanderwellen auch an einer zweiten Messstelle der Leitung zu detektieren, das System dazu eingerichtet ist, bei einem symmetrischen Fehler oder einem Fehler ohne Erdberührung an der ersten und der zweiten Messstelle die Zeitpunkte des Eintreffens jeweiliger Wellenfronten der jeweiligen Wanderwellen zu bestimmen, das System dazu eingerichtet ist, Differenzen zwischen den Zeitpunkten einerseits der zuerst eintreffenden Wellenfront und andererseits einer Mehrzahl von weiteren Wellenfronten zu bilden, das System dazu eingerichtet ist, für die erste und die zweite Messstelle unter Verwendung der Differenzen eine Folge potentieller Fehlerorte zu bilden, und das System dazu eingerichtet ist, denjenigen Fehlerort aus den Folgen potentieller Fehlerorte als tatsächlichen Fehlerort auszuwählen, für den die Summe aus dem Abstand zwischen der ersten Messstelle und dem ausgewählten Fehlerort und dem Abstand zwischen der zweiten Messstelle und dem ausgewählten Fehlerort der Länge der Leitung zwischen den beiden Messstellen entspricht.

Mit einem solchen System kann der Fehlerort auch bei Fehlerarten, bei denen eine modale 0-Komponente nicht ausgeprägt ist, zuverlässig bestimmt werden.

Vorzugsweise weist das System eine der Anzahl der Leitungsenden entsprechende Anzahl von Fehlerortungseinrichtungen auf. Alternativ kann das System auch eine zentrale Fehlerortungseinrichtung aufweisen, die über geeignete Messeinrichtungen die Messwerte der einzelnen Messstellen der Leitung ermitteln kann.

Hinsichtlich des erfindungsgemäßen Systems gelten alle zu dem erfindungsgemäßen Verfahren voranstehend und nachfolgend gemachten Ausführungen und umgekehrt in entsprechender Weise, insbesondere ist das erfindungsgemäße System zur Durchführung des erfindungsgemäßen Verfahrens in jeder beliebigen Ausführungsform oder einer Kombination beliebiger Ausführungsformen eingerichtet. Auch hinsichtlich der Vorteile des erfindungsgemäßen Systems wird auf die zu dem erfindungsgemäßen Verfahren beschriebenen Vorteile verwiesen.

Die Erfindung wird nachfolgend anhand eines Ausführungsbeispiels näher erläutert. Die spezifische Ausgestaltung des Ausführungsbeispiels ist für die allgemeine Ausgestaltung des erfindungsgemäßen Verfahrens, der erfindungsgemäßen Fehlerortungseinrichtung und des erfindungsgemäßen Systems in keiner Weise einschränkend zu verstehen; vielmehr können einzelne Ausgestaltungsmerkmale des Ausführungsbeispiels in beliebiger Weise frei untereinander und mit den voranstehend beschriebenen Merkmalen kombiniert werden.

Hierzu zeigen

Figur 1     eine schematische Ansicht eines Systems zur Wanderwellen-Fehlerortung nach dem Stand der Technik;

Figur 2     eine schematische Ansicht einer Leitung eines elektrischen Energieversorgungsnetzes zur Erläuterung der einseitigen Wanderwellen-Fehlerortung mit modalen Komponenten;

Figur 3     Diagramme mit während eines Fehlers gemessenen Strömen;

Figur 4     ein Diagramm zur Erläuterung der einseitigen Wanderwellen-Fehlerortung mit modalen Komponenten;

Figur 5     eine schematische Ansicht eines Ausführungsbeispiels einer Fehlerortungseinrichtung;

Figur 6     Diagramme zur Erläuterung der messtechnischen Ermittlung von Ausbreitungsgeschwindigkeiten der modalen Komponenten;

Figur 7     eine schematische Ansicht einer Leitung zur Erläuterung der WanderwellenFehlerortung unter Hinzunahme der Ergebnisse einer zweiten Messstelle;

Figur 8     Diagramme zur Erläuterung der zweiseitigen Wanderwellen-Fehlerortung mit modalen Komponenten; und

Figur 9     Diagramme zur Erläuterung der Wanderwellen-Fehlerortung unter Hinzunahme der Ergebnisse einer zweiten Messstelle.

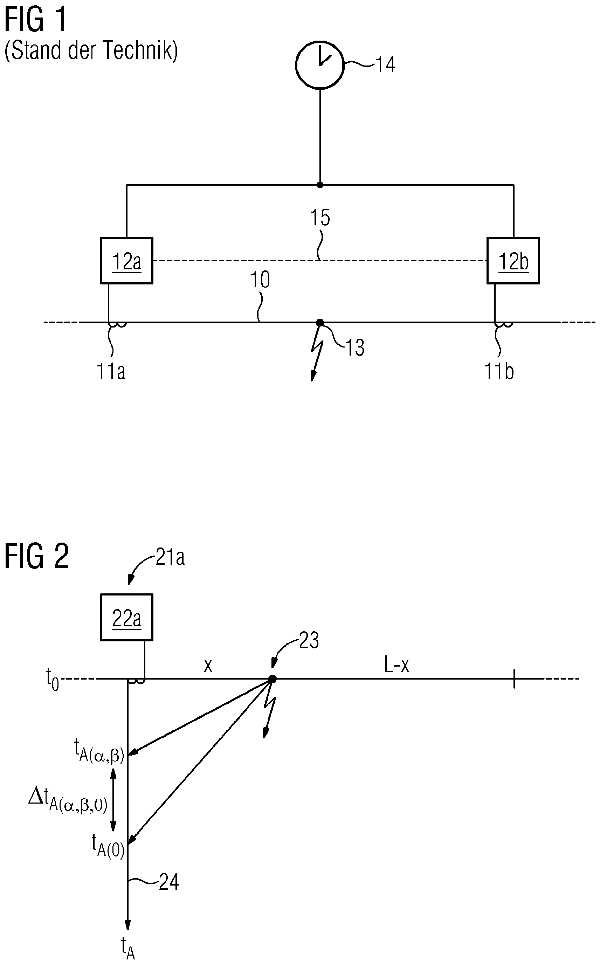

Figur 1 zeigt eine schematische Ansicht einer Leitung 10 eines ansonsten nicht näher dargestellten mehrphasigen Energieversorgungsnetzes. An Messstellen 11a, 11b an beiden Leitungsenden der Leitung 10 sind Messeinrichtungen 12a, 12b vorgesehen, mit denen sich im Fehlerfall von einer Fehlerstelle 13 aus entlang der Leitung 10 in beiden Richtungen ausbreitende Wanderwellen erfasst werden. Da sich die Wanderwellen auf der Leitung 10 mit Lichtgeschwindigkeit ausbreiten, kann anhand der Zeitdifferenz, mit der die Wanderwellen an beiden Messstellen 11a, 11b eintreffen, auf den Fehlerort 13 geschlossen werden. Allerdings wird dazu eine hochgenaue Zeitsynchronisation der beiden Messgeräte (z.B. durch einen externen Zeitgeber 14) sowie eine genaue Zeitstempelung bei der Messwertaufnahme benötigt. Außerdem ist eine Kommunikationsverbindung 15 zwischen beiden Messgeräten 12a, 12b erforderlich.

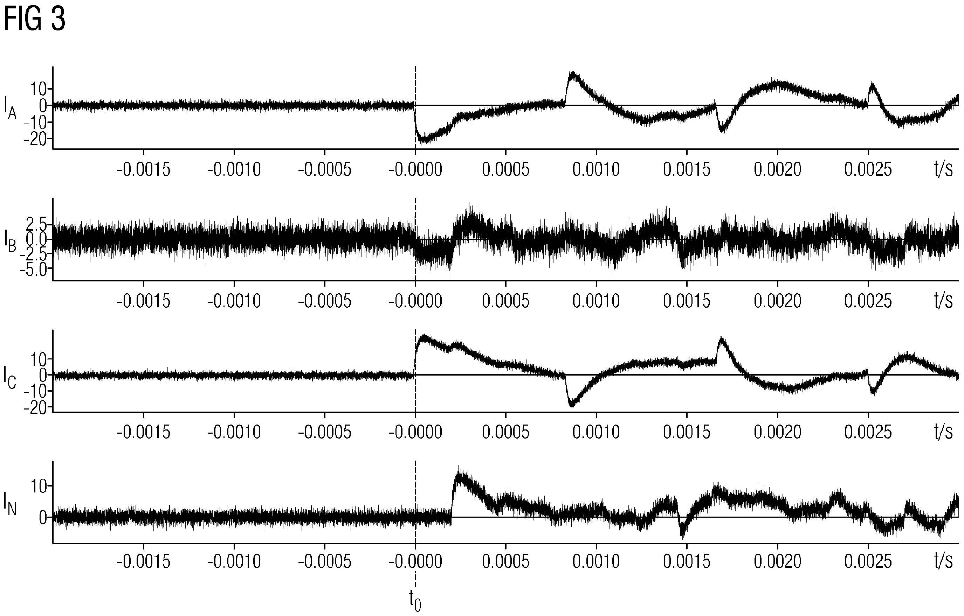

In Figur 2 ist ein Ausführungsbeispiel einer Fehlerortungseinrichtung 21 zur einseitigen Wanderwellen-Fehlerortung gemäß der Erfindung dargestellt. Die Fehlerortung wird hierbei basierend auf den lokal an einer einzigen Messstelle erfassten Messwerten durchführt. Die Idee ist dabei, die unterschiedlichen Ausbreitungsgeschwindigkeiten der modalen Komponenten einer Wanderwelle zum Zwecke der Fehlerortung zu verwenden. Hierzu zeigt Figur 2 in schematischer Ansicht eine mehrphasige Leitung 20 eines elektrischen Energieversorgungsnetzes. An einer ersten Messstelle 21a ist eine Fehlerortungseinrichtung 22a vorgesehen, mit der Phasenströme der einzelnen Phasenleiter der Leitung 20 erfasst werden. An einem Fehlerort 23 sei ein elektrischer Kurz- oder Erdschluss aufgetreten. Hierdurch wird eine Wanderwelle ausgelöst, die sich (auch) in Richtung der ersten Messstelle 21a ausbreitet. Die Wanderwelle wird mittels der Fehlerortungseinrichtung 22a an der ersten Messstelle 21a durch Messung der Phasenströme der einzelnen Phasenleiter der Leitung 20 detektieren. Da es sich bei einer Wanderwelle um ein transientes Ereignis mit im Vergleich zur Netzfrequenz hoher Frequenz (z.B. mehrere Hundert Hertz) handelt, ist zu ihrer Erfassung eine entsprechend hohe Abtastrate (z.B. im Megahertz-Bereich) einzusetzen. Figur 3 zeigt beispielhaft die Verläufe der gemessenen Phasenströme $I_A$, $I_B$, $I_C$ und des gemessenen Erdstroms $I_N$ (modale Nullkomponente) während eines zweipoligen Fehlers mit Erdbeteiligung, der zum Zeitpunkt $t_0$ eintritt. Deutlich erkennt man die den Verläufen überlagerten Wanderwellen.

Die Wanderwellen lassen sich in modale Komponenten zerlegen, die zumindest teilweise unterschiedliche Ausbreitungsgeschwindigkeiten haben. So kann beispielsweise mittels der sogenannten Clarke-Transformation eine Wanderwelle in eine modale $\alpha$-Komponente, eine modale $\beta$-Komponente und eine modale 0-Komponente zerlegt werden. Während die modale $\alpha$-Komponente und die modale $\beta$-Komponente gleiche Ausbreitungsgeschwindigkeiten aufweisen, besitzt die modale 0-Komponente eine signifikant geringere Ausbreitungsgeschwindigkeit, so dass die modalen Komponenten teilweise zu unterschiedlichen Zeitpunkten an der ersten Messstelle 21a eintreffen. In Figur 2 ist dies durch eine senkrecht zur Leitung 20 angedeutete Zeitachse 24 dargestellt, auf der die wesentlichen Zeitpunkte eingetragen sind. Zum (unbekannten) Zeitpunkt $t_0$, an dem der Fehler eingetreten ist, wird die Wanderwelle ausgelöst. Zum Zeitpunkt $t_{A(\alpha,\beta)}$ treffen gleichzeitig die modale $\alpha$-Komponente und die modale $\beta$-Komponente der Wanderwelle an der ersten Messstelle 21a ein. Zum Zeitpunkt $t_{A(0)}$ trifft schließlich die modale 0-Komponente bei der ersten Messstelle 21a ein.

Es lassen sich dann folgende Gruppengleichungen für die Messstelle 21a erstellen:

$$x = (t_{A(\alpha,\beta)} - t_0) \cdot v_{(\alpha,\beta)}$$

$$x = (t_{A(0)} - t_0) \cdot v_{(0)}$$

wobei x den Abstand zwischen der ersten Messstelle 21a und dem Fehlerort 23, $v_{(\alpha,\beta)}$ die Ausbreitungsgeschwindigkeit der modalen $\alpha$-Komponente bzw. $\beta$-Komponente und $v_{(0)}$ die Ausbreitungsgeschwindigkeit der modalen 0-Komponente angeben. Für die Bestimmung des Abstands x zum Fehlerort 23 werden die Gleichungen miteinander kombiniert, indem eine Gleichung nach der Unbekannten $t_0$ umstellt und sie in die andere Gleichung einsetzt. Damit ergib sich:

$$x = (t_{A(0)} - t_{A(\alpha,\beta)} + \frac{x}{v_{(\alpha,\beta)}}) \cdot v_{(0)}$$

Nach einer Umstellung kann man die Gleichung in eine Form umwandeln, aus der sich der Abstand x zum Fehlerort 23 direkt ermitteln lässt:

$$x = \frac{\Delta t_{A(\alpha,\beta,0)} v_{(0)}}{1 - \frac{v_{(0)}}{v_{(\alpha,\beta)}}}$$

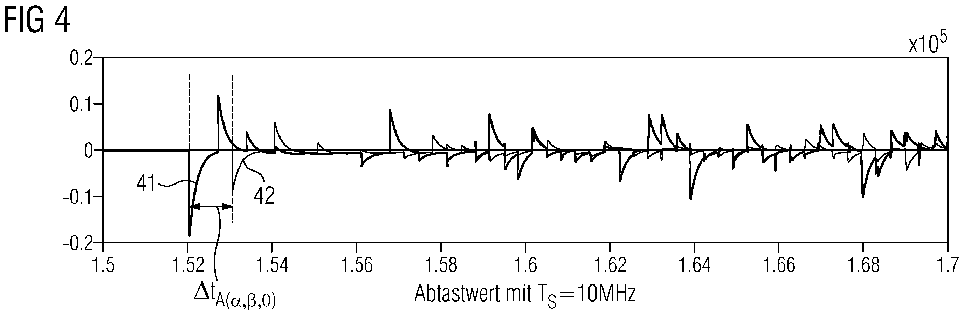

wobei $\Delta t_{A(\alpha,\beta,0)}$ die Zeitdifferenz zwischen dem Eintreffen der modalen 0-Komponente und der modalen $\alpha$-Komponente bzw. $\beta$-Komponente der Wanderwelle angibt. Wie man aus der Gleichung erkennen kann, ist die Information über gesamte Leitungslänge L nicht erforderlich. Figur 4 zeigt in einem Diagramm beispielhaft einen Verlauf 41 der modalen $\alpha$-Komponente bzw. $\beta$-Komponente sowie einen Verlauf 42 der 0-Komponente einer Wanderwelle. Bei Kenntnis der Ausbreitungsgeschwindigkeiten der jeweiligen modalen Komponenten und der gemessenen Zeitdifferenz $\Delta t_{A(\alpha,\beta,0)}$ lässt sich mit der obigen Gleichung der Abstand x zum Fehlerort 23 bestimmen.

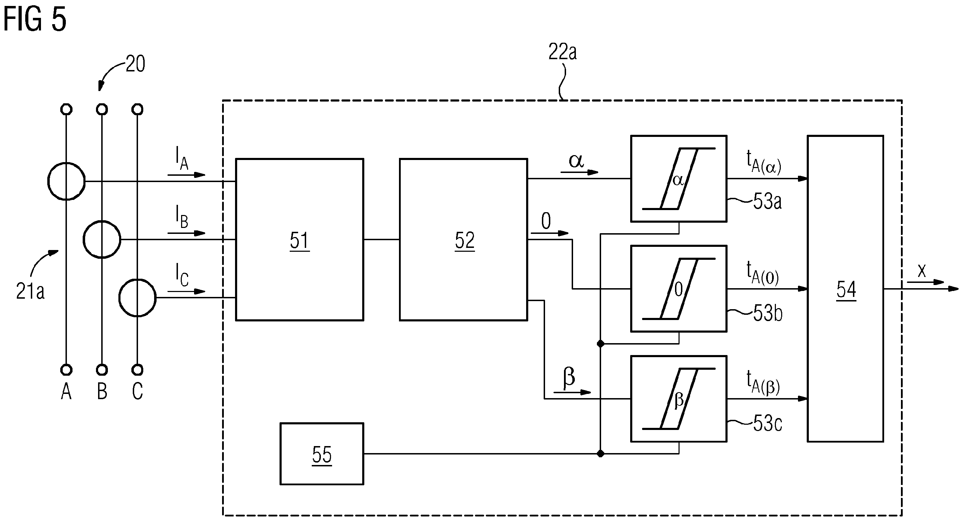

In Figur 5 ist beispielhaft die Fehlerortungseinrichtung 22a im Detail gezeigt. Wie bereits zu Figur 2 erläutert werden an der Messstelle 21a der Leitung 20 mittels Stromwandlern Phasenleiterströme $I_A$, $I_B$ und $I_C$ erfasst und mittels eines Bandpassfilters 51 gefiltert. Durch die Bandpassfilterung wird das Spektrum der erfassten Signals auf einen Frequenzbereich eingeschränkt, in dem sich die Ausbreitungsgeschwindigkeit der modalen 0-Komponente der erfassten Phasenströme nicht oder nur vernachlässigbar ändert. Anschließend wird in Transformationsblock 52 eine Clarke-Transformation der gefilterten Phasenströme durchgeführt, um die modalen Komponenten voneinander zu separieren. Ausgangsseitig gibt der Transformationsblock 52 eine modale 0-Komponente sowie mindestens eine der modalen $\alpha$- bzw. $\beta$-Komponenten ab. Diese werden je für sich Detektorblöcken 53a-c zugeführt. In bekannter Weise werden hier die Zeitpunkte $t_{A(\alpha)}$, $t_{A(\beta)}$ und $t_{A(0)}$ des Eintreffens einer Wellenfront mit einem Wellenfront-Detektor (z.B. Sprungdetektor) jeweils separat für die einzelnen modalen Komponenten bestimmt und an eine Auswerteinrichtung 54 übergeben. Dazu sind die Detektorblöcke 53a-c mit dem Zeitsignal eines internen Zeitgebers 55 beaufschlagt. Der Zeitgeber kann beispielsweise durch ein externes Zeitsignal synchron gehalten werden. Mittels der Auswerteinrichtung 54 wird anschließend der gesuchte Abstand x zum Fehlerort durch eine Differenzbildung der Zeitpunkte des Eintreffens der detektierten Wellenfront der modalen $\alpha$- und 0-Komponente oder der modalen $\beta$- und 0-Komponente mittels der oben gezeigten Gleichung bestimmt. Der Abstand kann ausgangsseitig von der Fehlerortungseinrichtung 22a ausgegeben werden und beispielsweise für die grafische Anzeige des Fehlerortes mittels einer in Figur 5 nicht gezeigten Anzeigeeinrichtung verwendet werden. Außerdem kann der Abstand x in Form einer elektronischen Nachricht an ein Wartungsteam gesendet werden, damit dieses den Fehler in Augenschein nimmt und behebt.

Bei der Fehlerortungseinrichtung 22a kann es sich um eine in der Nähe der Messstelle 21a platzierte Einrichtung handeln. Diese kann ein separates Gerät sein oder in ein bestehendes Gerät (z.B. ein Schutzgerät, einen Störschreiber etc.) integriert sein. Alternativ kann die Fehlerortungseinrichtung 22a auch entfernt von der Messstelle ausgebildet sein und beispielsweise durch eine Leitstelleneinrichtung oder ein Cloudcomputingsystem mit entsprechendem Cloudservice ausgebildet sein.

Die oben beschriebene Vorgehensweise eignet sich insbesondere bei Fehlerarten, bei denen eine ausgeprägte modale 0-Komponente vorhanden ist (insbesondere unsymmetrische Kurzschlüssen mit Erdbeteiligung). Bei Fehlerarten mit schwach oder gar nicht ausgeprägter modaler 0-Komponente (z.B. symmetrische Kurzschlüssen, Kurzschlüsse ohne Erdbeteiligung) bietet es sich an, zur Durchführung der Fehlerortung eine Vergleichsauswertung mit einer anderen Messstelle (z.B. am gegenüberliegenden Leitungsende) durchzuführen. Dies wird an späterer Stelle näher erläutert.

Zur Bestimmung des Abstands x gemäß der oben gezeigten Gleichung ist neben den Zeitpunkten des Eintreffens der entsprechenden modalen Komponente an der Messstelle 21a auch eine Information über die Ausbreitungsgeschwindigkeiten der jeweiligen modalen Komponenten erforderlich.

Die Ausbreitungsgeschwindigkeiten von modalen Komponenten lassen sich prinzipiell auf zwei Arten bestimmen: rechnerisch und messtechnisch. Bei der Berechnung kann man auf verschiedene Methoden zurückgreifen, die zum gleichen Ergebnis führen, wenn die Leitung (Freileitung bzw. Kabel) als geometrisch symmetrisch betrachtet werden kann:

Beispielsweise lässt sich die exakte Berechnung der Ausbreitungsgeschwindigkeiten mit einer Eigenwertanalyse durchführen. Da die Impedanz-Matrizen $Z(j\omega)$ und Admittanz-Matrizen $Y(j\omega)$ für die mathematische Modellbeschreibung der Leitung symmetrisch sind, lässt sich eine Eigenwertzerlegung anwenden. Besonders bei Mehrfachsystemen oder Parallelleitungen ist diese Variante sehr effektiv, weil sich alle modalen Komponenten genau ermitteln lassen.

Aus den Modellen für Spannung $u(x,j\omega)$ und Strom $i(x,j\omega)$ der Leitung folgt:

$$\frac{\partial^2 u(x,j\omega)}{\partial x^2} = Z(j\omega)Y(j\omega) \cdot u(x,j\omega)$$

$$\frac{\partial^2 i(x,j\omega)}{\partial x^2} = Y(j\omega)Z(j\omega) \cdot i(x,j\omega)$$

Daraus ergibt sich:

$$Z(j\omega)Y(j\omega) = T_{mod\_u}^{-1} \Lambda T_{mod\_u}$$

$$Y(j\omega)Z(j\omega) = T_{mod\_i}^{-1} \Lambda T_{mod\_i}$$

wobei A eine Diagonalmatrix ist und mit $T_{mod}$ orthogonale Vektoren dargestellt werden.

$$T_{mod\_u}\frac{\partial^2 u(x,j\omega)}{\partial x^2} = \Lambda T_{mod\_u} \cdot u(x,j\omega)$$

$$T_{mod\_i}\frac{\partial^2 i(x,j\omega)}{\partial x^2} = \Lambda T_{mod\_i} \cdot i(x,j\omega)$$

Nach der Einführung der folgenden Bezeichnungen

$$u_{mod} = T_{mod\_u} \cdot u(x,j\omega)$$

$$i_{mod} = T_{mod\_i} \cdot i(x, j\omega)$$

können die phasenbezogenen Größen entkoppelt werden:

$$\frac{\partial^2 u_{mod}(x, j\omega)}{\partial x^2} = \Lambda \cdot u_{mod}(x, j\omega)$$

$$\frac{\partial^2 i_{mod}(x, j\omega)}{\partial x^2} = \Lambda \cdot i_{mod}(x, j\omega)$$

Aus der Diagonalmatrix $\Lambda$ lassen sich die Geschwindigkeiten der einzelnen modalen Komponenten berechnen:

$$v_{mod} = \omega / Im\{\sqrt{\Lambda}\}$$

Alternativ zur Eigenwertanalyse können die Ausbreitungsgeschwindigkeiten auch mittels der Clarke-Transformation berechnet werden. Diese ist vorzugsweise für einfache Systeme geeignet und bietet eine sehr gute Entkopplung zwischen den Phasen an. Dafür lässt sich folgende Transformationsmatrix erstellen:

$$T = \frac{2}{3} \begin{bmatrix} 1 & -0.5 & -0.5 \\ 0 & \frac{\sqrt{3}}{2} & -\frac{\sqrt{3}}{2} \\ 0.5 & 0.5 & 0.5 \end{bmatrix}$$

Beispielhaft sei ein System mit folgenden Systemmatrizen für Impedanz und Admittanz angenommen:

$$Z = \begin{bmatrix} 0.187 + j0.858 & 0.098 + j0.3705 & 0.098 + j0.3705 \\ 0.098 + j0.3705 & 0.187 + j0.858 & 0.098 + j0.3705 \\ 0.098 + j0.3705 & 0.098 + j0.3705 & 0.187 + j0.858 \end{bmatrix} \Omega$$

$$Y = 10^{-5} \begin{bmatrix} j0.3 & -j0.036 & -j0.036 \\ -j0.036 & j0.3 & -j0.036 \\ -j0.036 & -j0.036 & j0.3 \end{bmatrix} S$$

Eine Umwandlung in das $\alpha$-, $\beta$- und 0-System ergibt:

$$Z_{\alpha\beta0} = TZT^{-1} = \begin{bmatrix} 0.0894 + j0.487 & 0 & 0 \\ 0 & 0.0894 + j0.487 & 0 \\ 0 & 0 & 0.383 + j1.599 \end{bmatrix} \Omega$$

$$Y_{\alpha\beta0} = TYT^{-1} = 1e^{-5} \begin{bmatrix} j0.336 & 0 & 0 \\ 0 & j0.336 & 0 \\ 0 & 0 & j0.229 \end{bmatrix} S$$

Daraus ergeben sich folgende zu betrachtenden Ausbreitungskonstanten und Wellenimpedanzen:

$$\gamma_{\alpha\beta0} = \begin{bmatrix} 0.0001 + j0.00128 & 0 & 0 \\ 0 & 0.0001 + j0.00128 & 0 \\ 0 & 0 & 0.0002 + j0.0019 \end{bmatrix}$$

$$Z_{C\alpha\beta0} = 10^2 \begin{bmatrix} 3.821 - j0.3475 & 0 & 0 \\ 0 & 3.821 - j0.3475 & 0 \\ 0 & 0 & 8.411 - j0.994 \end{bmatrix} \Omega$$

Aus den Ausbreitungskonstanten lassen sich Ausbreitungsgeschwindigkeiten ausrechnen:

$$v_{\alpha,\beta,0} = \omega / Im\{\sqrt{\gamma_{\alpha,\beta,0}}\}$$

Schließlich eignet sich z.B. auch die sogenannte Dommel-Transformation als eine Form einer linearen Transformation, um das phasige System in die modalen Komponenten umzuwandeln.

Neben einer rechnerischen Ermittlung der Ausbreitungsgeschwindigkeiten der jeweiligen modalen Komponenten, kann eine Bestimmung auch mit Hilfe der Messtechnik erfolgen. Dafür muss die Länge L der gesamten Leitung bekannt sein.

Für die messtechnische Ermittlung wird eine Wanderwelle künstlich erzeugt und vermessen. Um einen kontrollierten Wanderwellen-Effekt zu erhalten, kann man in Energieversorgungsnetzen einen sogenannten einpoligen Schaltungstest durchführen. Hierzu wird vorgeschlagen einen Zu- oder Abschaltvorgang auf der fehlerfreien Leitung durchzuführen, dies kann beispielsweise während der Inbetriebnahme der Fehlerortungseinrichtung stattfinden. Die Zeitpunkte des Eintreffens der modalen Komponenten werden wie oben zu Figur 5 erläutert bestimmt. Vorzugsweise werden auch hierbei die Signale bandpassgefiltert, um eine konstante Ausbreitungsgeschwindigkeit der modalen Komponenten im betrachteten Frequenzbereich zu sichern.

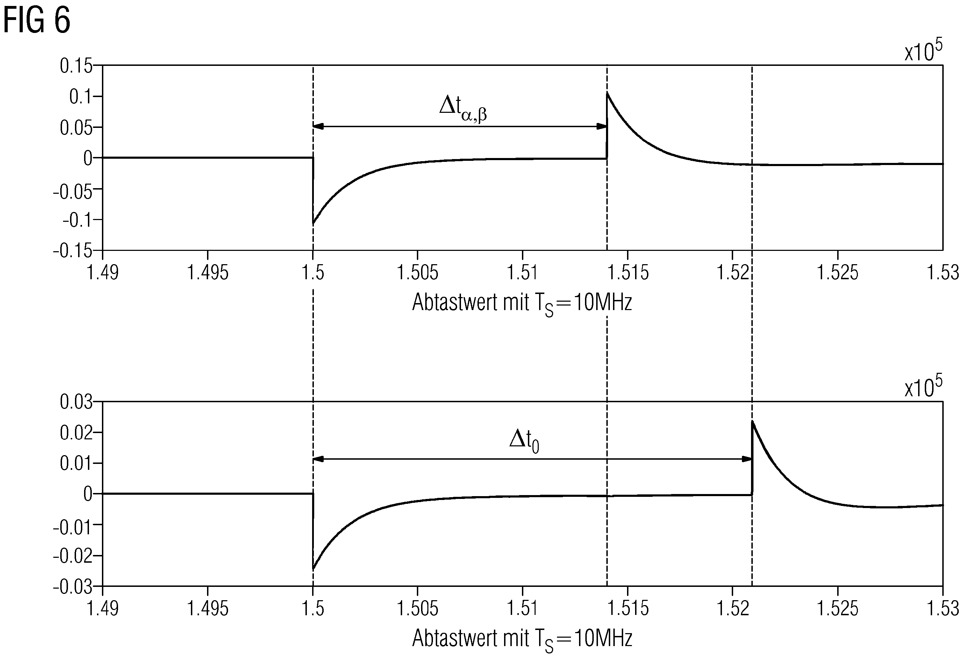

In diesem Zusammenhang zeigt Figur 6 zwei Diagramme, in denen messtechnisch aufgenommene Verläufe von modalen Komponenten einer Wanderwelle dargestellt sind (oben: $\alpha$- bzw. $\beta$-Komponente; unten 0-Komponente), die während eines Schaltungstests erzeugt worden ist. Daraus ergeben sich unterschiedliche Ausbreitungsgeschwindigkeiten $v_{(0)}$ und $v_{(\alpha,\beta)}$ der Wanderwellen:

$$v_{(0)} = \frac{2L}{\Delta t_0}$$

$$v_{(\alpha,\beta)} = \frac{2L}{\Delta t_{\alpha,\beta}}$$

Als Referenzzeitpunkt wird das Eintreffen der ersten Wellenfront verwendet und mit dem Zeitpunkt des Eintreffens der zweiten Wellenfront verglichen, so dass sich aus der Messung die Zeitdifferenzen $\Delta t_0$, $\Delta t_{\alpha,\beta}$ (vgl. Figur 6) ergeben, aus denen sich bei Kenntnis der Leitungslänge L die gesuchten Ausbreitungsgeschwindigkeiten ergeben.

Um Fehler bei der Messung, die auf eine Verwendung falscher Wellenfronten zurückzuführen sind, zu vermeiden, sollte darauf geachtet werden, dass die zweite Wellenfront im Bereich von Zeiten gesucht wird, die die Wanderwelle voraussichtlich benötigt, um die doppelte Länge (2L) der Leitung zurückzulegen. Weiterhin müssen die Wellenfronten der unterschiedlichen modalen Komponenten dieselbe Polarität aufweisen. Die erste erfasste Wellenfront wird als Referenzwelle genommen, auf die die Zeitdifferenz bezogen werden muss.

Die Bestimmung der Ausbreitungsgeschwindigkeiten kann einmalig bei der Inbetriebnahme der Fehlerortungseinrichtung durchgeführt werden. Alternativ kann die Bestimmung auch wiederholt erfolgen, z.B. bei der Durchführung geplanter einpoliger Schaltvorgänge. Die Messung lässt sich auch im Fall einen externen Fehlers durchführen.

Wie oben bereits erwähnt, ist es für die Funktionsweise des Fehlerortungsverfahrens nötig, dass eine modale 0-Komponente ausgeprägt ist. Dies ist bei unsymmetrischen Kurzschlüssen mit der Erdbeteiligung der Fall. Bei anderen Fehlerarten bietet sich ein Vergleich der Ergebnisse mit denen an einer anderen Messstelle, vorzugsweise am anderen Leitungsende an. Hierfür ist eine Zeitsynchronisation zwischen den Fehlerortungseinrichtungen an den Messstellen nicht erforderlich.

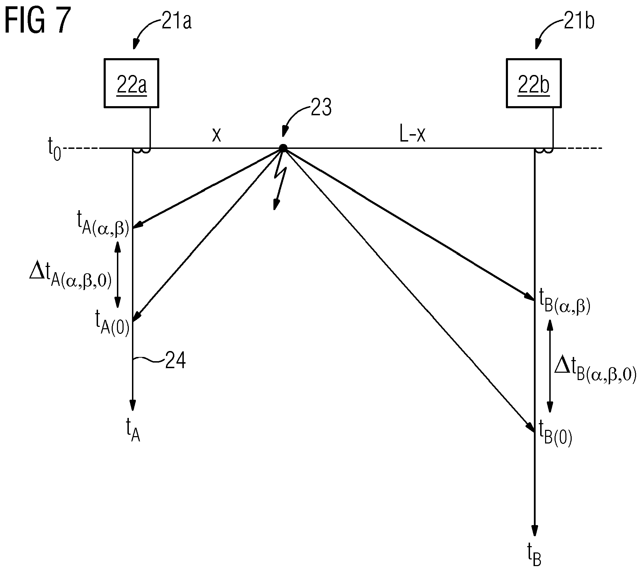

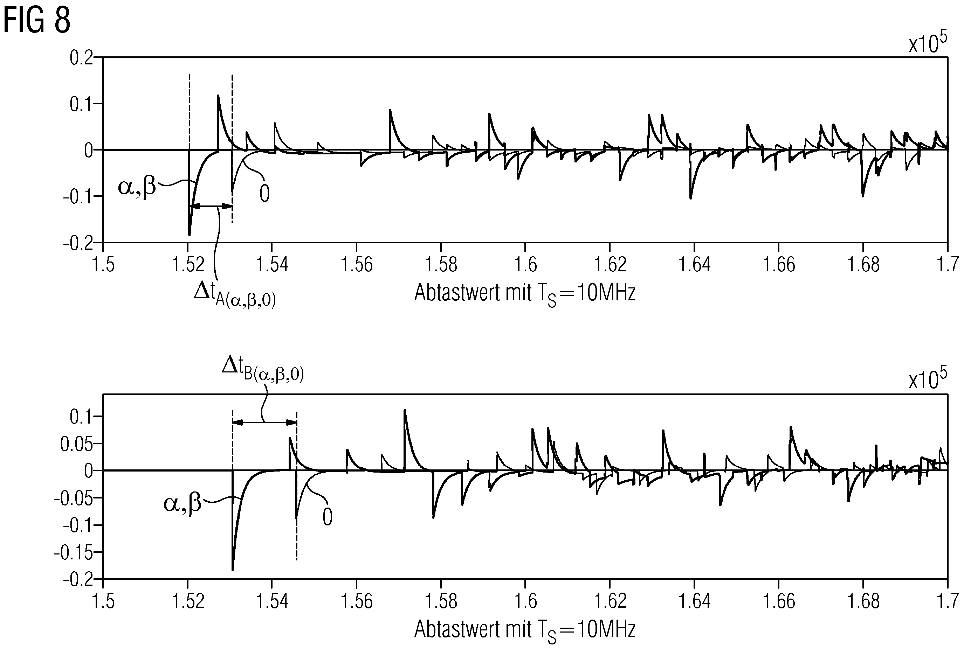

Die prinzipielle Vorgehensweise ist in Figur 7 angedeutet. Dabei werden für einander entsprechende Komponenten die Bezugszeichen aus Figur 2 verwendet. Gemäß Figur 7 ist ein System zur Fehlerortung dargestellt, bei dem neben der ersten Fehlerortungseinrichtung 22a eine zweite Fehlerortungseinrichtung 22b verwendet wird. Diese ist an einer zweiten Messstelle 21b angeordnet. Der Abstand zwischen beiden Messstellen 21a, 21b entspricht der Leitungslänge L. Die an dem Fehlerort entstehende Wanderwelle wird an beiden Messstellen 21a,b erfasst. Liegt eine Fehlerart mit ausgeprägter modaler 0-Komponente vor, kann der Abstand zum Fehlerort von beiden Messstellen 21a,b aus entsprechend der oben genannten Vorgehensweise bestimmt werden. Wie in Figur 8 angedeutet, wird durch die Bestimmung der Zeitpunkte, zu denen die unterschiedlichen modalen Komponenten an den beiden Messstellen 21a,b eintreffen, einerseits für die erste Messstelle 21a eine Zeitdifferenz $\Delta t_{A(\alpha,\beta,0)}$ und andererseits für die zweite Messstelle 21b eine Zeitdifferenz $\Delta t_{B(\alpha,\beta,0)}$ bestimmt. Der Abstand von der zweiten Messstelle 21b beträgt in diesem Fall L-x. Durch die beidseitige Bestimmung des Fehlerortes kann die Genauigkeit verbessert werden bzw. es kann das Ergebnis der einen Messstelle durch dasjenige der anderen Messstelle plausibilisiert werden.

Beispielhaft sei im Zusammenhang mit Figur 8 angenommen, dass an einem Fehlerort ein einpoliger Fehler vorliegt. Figur 8 zeigt für beide Messstellen die modalen Komponenten der Bandpass-gefilterten Wanderwellenverläufe. Der Fehlerort liegt bei einer Leitung mit L=150km Länge auf der Position von 60km von der ersten Messstelle 21a entfernt. Dementsprechend beträgt die Entfernung von der zweiten Messstelle 21b aus 90km. Die Durchführung des oben dargestellten Verfahrens zur Fehlerortbestimmung ergibt für die Fehlerortungseinrichtung 22a an der ersten Messstelle 21a eine Zeitdifferenz von $\Delta t_{A(\alpha,\beta,0)}$ = **100,8μs**. Für die Fehlerortungseinrichtung 22b an der zweiten Messstelle 21b ergibt sich eine Zeitdifferenz von $\Delta t_{B(\alpha,\beta,0)}$ = **151,5μs**. Nach dem Einsetzen der Zeitdifferenzen in die oben angegebene Gleichung für einseitige Fehlerortung mit modalen Komponenten erhält man folgende Ergebnisse:

$$x_A = \frac{100{,}8\mu s \cdot 196910 km/s}{1 - \dfrac{196910 km/s}{294290 km/s}} = 59{,}98km$$

$$x_B = \frac{151{,}5\mu s \cdot 196910 km/s}{1 - \dfrac{196910 km/s}{294290 km/s}} = 90{,}15km$$

Die Genauigkeit der Berechnung ergibt sich einerseits aus der Genauigkeit der Erfassung der Wellenfronten sowie andererseits aus der Genauigkeit der verwendeten Ausbreitungsgeschwindigkeiten der modalen Komponenten.

Liegt eine Fehlerart ohne ausgeprägte 0-Komponente vor, so werden zur Fehlerortbestimmung die Wanderwellen und ihre Reflektionen ausgewertet. Der Algorithmus funktioniert hierbei wie folgt:

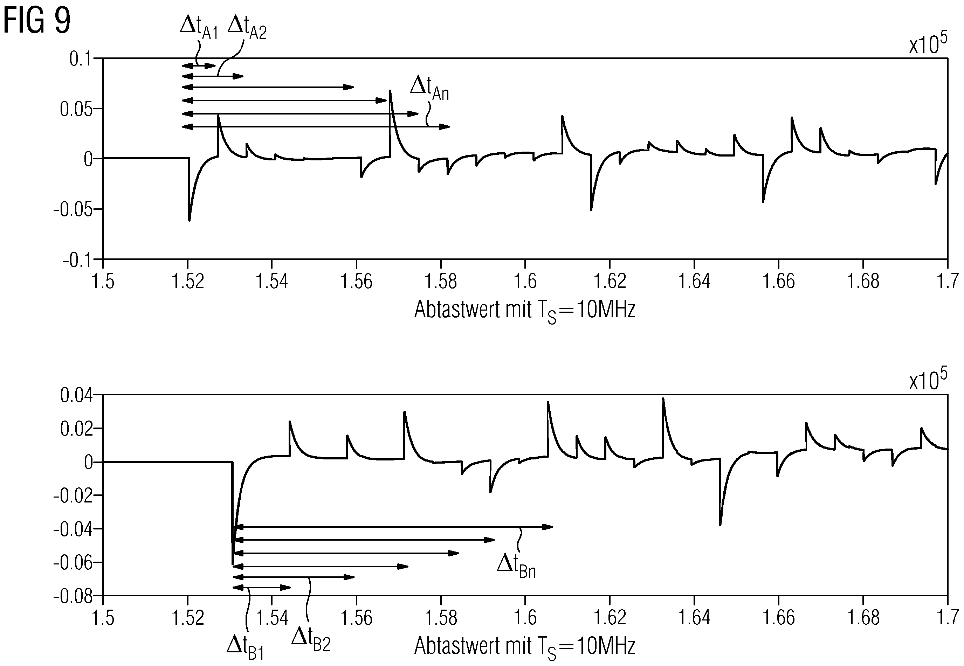

An der ersten Messstelle 21a werden alle Zeitdifferenzen zwischen der ersten kommenden Wellenfront der Wanderwelle und jeder weiteren folgenden Wanderwellenfronten $\Delta t_{A1}...t_{An}$ ermittelt. Eine entsprechende Ermittlung von Zeitdifferenzen $\Delta t_{B1}...\Delta t_{Bm}$ findet an der zweiten Messstelle 21b statt. Dies ist in Figur 9 beispielhaft dargestellt. Diese Zeitdifferenzen $\Delta t_{A1}...\Delta t_{An}$ und $\Delta t_{B1}...\Delta t_{Bm}$ geben mögliche Abstände zum Fehlerort an und können daher in potentielle Fehlerortungsergebnisse umgerechnet werden. Somit entsteht für die erste Messstelle eine erste Folge potentieller Fehlerorte $x_{A,FO}$:

$$x_{A,FO} = \left\{ \frac{v \cdot \Delta t_{A1}}{2}, \frac{v \cdot \Delta t_{A2}}{2}, ...., \frac{v \cdot \Delta t_{An}}{2} \right\}$$

Für die zweite Messstelle ergibt sich entsprechend eine zweite Folge potentieller Fehlerorte $x_{B,FO}$:

$$x_{B,FO} = \left\{ \frac{v \cdot \Delta t_{B1}}{2}, \frac{v \cdot \Delta t_{B2}}{2}, ...., \frac{v \cdot \Delta t_{Bm}}{2} \right\}$$

Durch Zusammenführung beider Folgen $x_{A,FO}$ und $x_{B,FO}$ in mindestens einer der Fehlerortungseinrichtungen können die Folgen miteinander kombiniert werden. Für den korrekte Fehlerort muss folgende Gleichung erfüllt werden:

$$x_{A,FO} + x_{B,FO} = L$$

$$\rightarrow \{\frac{v \cdot \Delta t_{Ai}}{2} + \frac{v \cdot \Delta t_{Bj}}{2} = L\}_{i,j}$$

Als Ausbreitungsgeschwindigkeit v wird hierfür die höchste ermittelte Ausbreitungsgeschwindigkeit der modalen Komponenten verwendet. Die Indizes i und j geben die Nummer der erfassten Wellenfront an, für die die obige Gleichung erfüllt wird.

Wie Figuren 8 und 9 zu entnehmen ist, treten auch Reflektionen auf, die nicht durch den Fehlerort, sondern z.B. durch weitere Leitungen im System hervorgerufen werden. Diese zusätzlichen Reflektionen erschweren die richtige Fehlerortung.

Aus diesem Grund müssen alle erfassten Wellenfronten plausibilisiert werden. Das kann unter Benutzung der Ergebnisse der jeweils anderen Messstelle durchgeführt werden. Dabei ist eine Zeitsynchronisierung der Fehlerortungseinrichtungen an den beiden Messstellen nicht nötig.

Beispielhaft sei angenommen, dass folgende Zeitdifferenzen $\Delta t_{A1}...\Delta t_{An}$ für die erste Messstelle ermittelt worden sind:

$$\Delta t_{Ai} = \{68\mu s, \ 136\mu s, 204\mu s, 408\mu s, 476\mu s, 644\mu s, ...\}$$

Hieraus ergibt sich eine erste Folge potentieller Fehlerorte $X_{A,FO}$:

$$x_{A,FO} = \{10km, 20km, 30km, 60km, 70km, 80km, ...\}$$

Für die zweite Messstelle ergeben sich folgende Zeitdifferenzen $\Delta t_{B1}...\Delta t_{Bm}$:

$$\Delta t_{Bj} = \{136\mu s, 272\mu s, 408\mu s, 544\mu s, 612\mu s, 748\mu s, ...\}$$

Hieraus ergibt sich eine zweite Folge potentieller Fehlerorte $x_{B,FO}$:

$$x_{B,FO} = \{20km, \ 40km, 60km, 80km, 90km, 110km, ...\}$$

Durch das Plausibilisieren der erhaltenen Resultate mit

$$x_{A,FO} + x_{B,FO} = L$$

und unter der Berücksichtigung, dass die Wellenfronten dieselbe Polarität aufweisen müssen, ergibt sich das Endergebnis als $x_{A,FO} = 60km$, $x_{B,FO} = 90km$.

Die Polarität der Wellenfronten, die zur Berechnung des Fehlerortes herangezogen werden, muss der Polarität der ersten Wellenfront entsprechen und an beiden Leitungsenden gleich sein (wenn als formelle Stromrichtung an beiden Leitungsenden in Richtung der Leitung gewählt wurde).

Werden zusätzlich Spannungen gemessen, muss die Multiplikation der Vorzeichen der Wellenfronten von Strom und Spannung bei einer Stromrichtung in Richtung der Leitung einen negativen oder bei definierter Stromrichtung in Richtung der Sammelschiene einen positiven Wert ergeben, wenn die Welle aus der Richtung der Leitung kommt.

Zusammenfassend wurde eine Vorgehensweise erläutert, wie durch einseitige Messungen von Wanderwellen eine Bestimmung des Fehlerortes stattfinden kann. Bei bestimmten Fehlerarten ist die Hinzunahme der Ergebnisse einer zweiten Messstelle nötig.

Obwohl die Erfindung vorstehend im Detail durch bevorzugte Ausführungsbeispiele näher illustriert und beschrieben worden ist, ist die Erfindung nicht durch die offenbarten Beispiele eingeschränkt und andere Variationen können vom Fachmann hieraus abgeleitet werden, ohne den Schutzumfang der nachfolgenden Patentansprüche zu verlassen.

**Patentansprüche**

1. Verfahren zum Bestimmen eines Fehlerortes (23) auf einer dreiphasigen Leitung (20) eines elektrischen Energieversorgungsnetzes, bei dem

   - an einer ersten Messstelle (21a) der Leitung (20) erste Strommesswerte erfasst werden, die jeweilige in den Phasen der der Leitung (20) fließende Phasenströme angeben;
   - unter Verwendung der ersten Strommesswerte sich bei einem Fehler vom Fehlerort (23) entlang der Leitung (20) zur ersten Messstelle (21a) ausbreitende Wanderwellen detektiert werden; und
   - mit einer Fehlerortungseinrichtung (22a) die detektierten Wanderwellen zur Ermittlung des Fehlerortes (23) ausgewertet werden;
   **dadurch gekennzeichnet, dass**
   - mit der Fehlerortungseinrichtung (22a) modale Komponenten der detektierten Wanderwelle bestimmt werden, wobei zumindest zwei der modalen Komponenten unterschiedliche Ausbreitungsgeschwindigkeiten entlang der Leitung (20) aufweisen; und
   - ein Abstand zwischen der ersten Messstelle (21a) und dem Fehlerort (23) unter Verwendung derjenigen Zeitpunkte ermittelt wird, zu denen die modalen Komponenten die erste Messstelle (21a) erreichen.

2. Verfahren nach Anspruch 1,
   **dadurch gekennzeichnet, dass**

   - eine Differenz zwischen denjenigen Zeitpunkten gebildet wird, zu denen die modalen Komponenten die erste Messstelle (21a) erreichen; und
   - der Abstand zwischen der ersten Messstelle (21a) und dem Fehlerort (23) unter Verwendung der Differenz sowie der Ausbreitungsgeschwindigkeit der jeweiligen modalen Komponente ermittelt wird.

3. Verfahren nach Anspruch 2,
   **dadurch gekennzeichnet, dass**

   - die Ausbreitungsgeschwindigkeit der jeweiligen modalen Komponente rechnerisch ermittelt wird.

4. Verfahren nach Anspruch 2,
   **dadurch gekennzeichnet, dass**

   - die Ausbreitungsgeschwindigkeit der jeweiligen modalen Komponente durch Messung ermittelt wird, indem die während eines einpoligen Schaltvorgangs auf der Leitung (20) im fehlerfreien Zustand entstehenden Wanderwellen in modale Komponenten zerlegt und diejenigen Zeitpunkte ermittelt werden, zu denen die jeweiligen modalen Komponenten die erste Messstelle (21a) erreichen.

5. Verfahren nach Anspruch 4,
   **dadurch gekennzeichnet, dass**

   - die Messung der Ausbreitungsgeschwindigkeit der jeweiligen modalen Komponente wiederholt durchgeführt wird.

6. Verfahren nach einem der vorangehenden Ansprüche,
   **dadurch gekennzeichnet, dass**

   - aus den jeweiligen Strommesswerten der einzelnen Phasenströme die modalen Komponenten mittels einer auf Eigenwerten basierenden Transformation zur Separierung von modalen Komponenten gebildet werden.

7. Verfahren nach einem der vorangehenden Ansprüche,
   **dadurch gekennzeichnet, dass**

   - die Strommesswerte mittels eines Bandpassfilters gefiltert werden, wobei der Bandpassfilter auf einen Frequenzbereich eingestellt ist, in dem die modalen Komponenten jeweils eine konstante Ausbreitungsgeschwindigkeit aufweisen.

8. Verfahren nach einem der vorangehenden Ansprüche,
**dadurch gekennzeichnet, dass**

- die von dem Fehlerort (23) ausgehenden Wanderwellen auch an einer zweiten Messstelle (21b) der Leitung detektiert werden;
- unter Verwendung der modalen Komponenten der an der zweiten Messstelle (21b) detektierten Wanderwellen ein Abstand zwischen der zweiten Messstelle (21b) und dem Fehlerort (23) ermittelt wird; und
- geprüft wird, ob die Summe aus dem Abstand zwischen der ersten Messstelle (21a) und dem Fehlerort (23) und dem Abstand zwischen der zweiten Messstelle (21b) und dem Fehlerort (23) der Länge der Leitung (20) zwischen den beiden Messstellen (21a,b) entspricht.

9. Verfahren nach einem der vorangehenden Ansprüche 1 bis 7,
**dadurch gekennzeichnet, dass**

- die von dem Fehlerort (23) ausgehenden Wanderwellen auch an einer zweiten Messstelle (21b) der Leitung detektiert werden;
- bei einem symmetrischen Fehler oder einem Fehler ohne Erdberührung an der ersten und der zweiten Messstelle die Zeitpunkte des Eintreffens jeweiliger Wellenfronten der jeweiligen Wanderwellen bestimmt werden;
- Differenzen zwischen den Zeitpunkten einerseits der zuerst eintreffenden Wellenfront und andererseits einer Mehrzahl von weiteren Wellenfronten gebildet werden;
- für die erste und die zweite Messstelle (21a,b) unter Verwendung der Differenzen eine Folge potentieller Fehlerorte gebildet wird; und
- derjenige Fehlerort aus den Folgen potentieller Fehlerorte als tatsächlicher Fehlerort (23) ausgewählt wird, für den die Summe aus dem Abstand zwischen der ersten Messstelle (21a) und dem ausgewählten Fehlerort und dem Abstand zwischen der zweiten Messstelle (21b) und dem ausgewählten Fehlerort (23) der Länge der Leitung (20) zwischen den beiden Messstellen (21a,b) entspricht.

10. Fehlerortungseinrichtung (22a) zum Bestimmen eines Fehlerortes (23) auf einer dreiphasigen Leitung (20) eines elektrischen Energieversorgungsnetzes, wobei die Fehlerortungseinrichtung (22a) dazu eingerichtet ist, erste Strommesswerte, die jeweilige an einer ersten Messstelle (21a) in der Leitung (20) fließende Phasenströme angeben, zu erfassen und wobei die Fehlerortungseinrichtung (22a) dazu eingerichtet ist, unter Verwendung der ersten Strommesswerte sich bei einem Fehler vom Fehlerort entlang der Leitung (20) zur ersten Messstelle (21a) ausbreitende Wanderwellen zu detektieren und die detektierten Wanderwellen zur Ermittlung des Fehlerortes (23) auszuwerten;
**dadurch gekennzeichnet, dass**

- die Fehlerortungseinrichtung (22a) dazu eingerichtet ist, modale Komponenten der detektierten Wanderwelle zu bestimmen, wobei zumindest zwei der modalen Komponenten unterschiedliche Ausbreitungsgeschwindigkeiten entlang der Leitung (20) aufweisen, und einen Abstand zwischen der ersten Messstelle (21a) und dem Fehlerort (23) unter Verwendung derjenigen Zeitpunkte zu ermitteln, zu denen die modalen Komponenten die erste Messstelle (21a) erreichen.

11. System mit mindestens zwei Fehlerortungseinrichtungen, die gemäß Anspruch 10 ausgebildet sind,
**dadurch gekennzeichnet, dass**

- das System dazu eingerichtet ist, die von dem Fehlerort (23) ausgehenden Wanderwellen auch an einer zweiten Messstelle (21b) der Leitung (20) zu detektieren und unter Verwendung der modalen Komponenten der an der zweiten Messstelle (21b) detektierten Wanderwellen einen Abstand zwischen der zweiten Messstelle (21b) und dem Fehlerort (23) zu ermitteln; und
- das System dazu eingerichtet ist, zu prüfen, ob die Summe aus dem Abstand zwischen der ersten Messstelle (21a) und dem Fehlerort (23) und dem Abstand zwischen der zweiten Messstelle 21b und dem Fehlerort (23) der Länge der Leitung (20) zwischen den beiden Messstellen (21a,b) entspricht.

12. System mit mindestens zwei Fehlerortungseinrichtungen, die gemäß Anspruch 10 ausgebildet sind,
**dadurch gekennzeichnet, dass**

- das System dazu eingerichtet ist, die von dem Fehlerort (23) ausgehenden Wanderwellen auch an einer zweiten Messstelle (21b) der Leitung (20) zu detektieren;
- das System dazu eingerichtet ist, bei einem symmetrischen Fehler oder einem Fehler ohne Erdberührung an der ersten und der zweiten Messstelle die Zeitpunkte des Eintreffens jeweiliger Wellenfronten der jeweiligen Wanderwellen zu bestimmen;
- das System dazu eingerichtet ist, Differenzen zwischen den Zeitpunkten einerseits der zuerst eintreffenden Wellenfront und andererseits einer Mehrzahl von weiteren Wellenfronten zu bilden;
- das System dazu eingerichtet ist, für die erste und die zweite Messstelle (21a,b) unter Verwendung der Differenzen eine Folge potentieller Fehlerorte zu bilden; und
- das System dazu eingerichtet ist, denjenigen Fehlerort aus den Folgen potentieller Fehlerorte als tatsächlichen Fehlerort (23) auszuwählen, für den die Summe aus dem Abstand zwischen der ersten Messstelle (21a) und dem ausgewählten Fehlerort und dem Abstand zwischen der zweiten Messstelle (21b) und dem ausgewählten Fehlerort (23) der Länge der Leitung (20) zwischen den beiden Messstellen (21a,b) entspricht.

**Claims**

1. Method for determining the location of a fault (23) on a three-phase line (20) of an electrical power supply network, in which method

   - first current measurement values, which indicate respective phase currents flowing through the phases of the line (20), are measured at a first measuring point (21a) of the line (20);
   - travelling waves propagating in the event of a fault from the location of the fault (23) along the line (20) to the first measuring point (21a) are detected using the first current measurement values; and
   - a fault locating device (22a) is used to evaluate the detected travelling waves in order to ascertain the location of the fault (23);
   **characterized in that**
   - the fault locating device (22a) is used to determine modal components of the detected travelling wave, wherein at least two of the modal components have different propagation speeds along the line (20); and
   - a distance between the first measuring point (21a) and the location of the fault (23) is ascertained using those times at which the modal components reach the first measuring point (21a) .

2. Method according to Claim 1,
   **characterized in that**

   - a difference between those times at which the modal components reach the first measuring point (21a) is formed; and
   - the distance between the first measuring point (21a) and the location of the fault (23) is ascertained using the difference and the propagation speed of the respective modal component.

3. Method according to Claim 2,
   **characterized in that**

   - the propagation speed of the respective modal component is ascertained computationally.

4. Method according to Claim 2,
   **characterized in that**

   - the propagation speed of the respective modal component is ascertained by measurement whereby the travelling waves occurring on the line (20) in the fault-free state during a single-pole switching operation are broken down into modal components, and those times at which the respective modal components reach the first measuring point (21a) are ascertained.

5. Method according to Claim 4,
   **characterized in that**

   - the measurement of the propagation speed of the respective modal component is carried out repeatedly.

6. Method according to one of the preceding claims,
   **characterized in that**

- the modal components are formed from the respective current measurement values of the individual phase currents by means of a transformation for separating modal components based on eigenvalues.

7. Method according to one of the preceding claims, **characterized in that**

   - the current measurement values are filtered by means of a bandpass filter, wherein the bandpass filter is tuned to a frequency range in which the modal components each have a constant propagation speed.

8. Method according to one of the preceding claims, **characterized in that**

   - the travelling waves emanating from the location of the fault (23) are also detected at a second measuring point (21b) of the line;
   - a distance between the second measuring point (21b) and the location of the fault (23) is ascertained using the modal components of the travelling waves detected at the second measuring point (21b); and
   - it is checked whether the sum of the distance between the first measuring point (21a) and the location of the fault (23) and the distance between the second measuring point (21b) and the location of the fault (23) corresponds to the length of the line (20) between the two measuring points (21a,b).

9. Method according to one of preceding Claims 1 to 7, **characterized in that**

   - the travelling waves emanating from the location of the fault (23) are also detected at a second measuring point (21b) of the line;
   - in the event of a symmetrical fault or of a fault without earthing, the times of arrival of respective wavefronts of the respective travelling waves at the first and the second measuring point are determined;
   - differences between the times of the wavefront that is first to arrive, on the one hand, and of a plurality of further wavefronts, on the other hand, are formed;
   - a sequence of potential fault locations is formed for the first and the second measuring point (21a,b) using the differences; and
   - that fault location from the sequences of potential fault locations for which the sum of the distance between the first measuring point (21a) and the selected fault location and the distance between the second measuring point (21b) and the selected fault location (23) corresponds to the length of the line (20) between the two measuring points (21a,b) is selected as the actual location of the fault (23).

10. Fault locating device (22a) for determining the location of a fault (23) on a three-phase line (20) of an electrical power supply network, wherein the fault locating device (22a) is configured to measure first current measurement values which indicate respective phase currents flowing through the line (20) at a first measuring point (21a) and wherein the fault locating device (22a) is configured to detect travelling waves propagating in the event of a fault from the location of the fault along the line (20) to the first measuring point (21a) using the first current measurement values and to evaluate the detected travelling waves in order to ascertain the location of the fault (23); **characterized in that**

    - the fault locating device (22a) is configured to determine modal components of the detected travelling wave, wherein at least two of the modal components have different propagation speeds along the line (20), and to ascertain a distance between the first measuring point (21a) and the location of the fault (23) using those times at which the modal components reach the first measuring point (21a).

11. System having at least two fault locating devices which are designed according to Claim 10, **characterized in that**

    - the system is configured to also detect the travelling waves, emanating from the location of the fault (23), at a second measuring point (21b) of the line (20) and to ascertain a distance between the second measuring point (21b) and the location of the fault (23) using the modal components of the travelling waves detected at the second measuring point (21b); and
    - the system is configured to check whether the sum of the distance between the first measuring point (21a) and the location of the fault (23) and the distance between the second measuring point (21b) and the location of the fault (23) corresponds to the length of the line (20) between the two measuring points (21a,b).

12. System having at least two fault locating devices which are designed according to Claim 10,
**characterized in that**

- the system is configured to also detect the travelling waves, emanating from the location of the fault (23), at a second measuring point (21b) of the line (20);
- the system is configured, in the event of a symmetrical fault or of a fault without earthing, to determine the times of arrival of respective wavefronts of the respective travelling waves at the first and the second measuring point;
- the system is configured to form differences between the times of the wavefront that is first to arrive, on the one hand, and of a plurality of further wavefronts, on the other hand;
- the system is configured to form a sequence of potential fault locations for the first and the second measuring point (21a,b) using the differences; and
- the system is configured to select that fault location from the sequences of potential fault locations for which the sum of the distance between the first measuring point (21a) and the selected fault location (23) and the distance between the second measuring point (21b) and the selected fault location (23) corresponds to the length of the line (20) between the two measuring points (21a,b) as the actual location of the fault (23) .

**Revendications**

1. Procédé de détermination de l'emplacement (23) d'un défaut sur une ligne (20) triphasée d'un réseau d'alimentation en énergie électrique, dans lequel

- on relève, en un premier point (21a) de mesure de la ligne (20), des premières valeurs de mesure de courant, qui indiquent respectivement des courants de phase passant dans les phases de la ligne (20) ;
- en utilisant les premières valeurs de mesure de courant, on détecte, s'il y a un défaut, des ondes progressives se propageant le long de la ligne (20) de l'emplacement (23) du défaut au premier point (21a) de mesure ; et
- par un dispositif (22a) de localisation de défaut, on exploite les ondes progressives détectées pour la détermination de l'emplacement (23) du défaut ;
**caractérisé en ce que**
- on détermine, par le dispositif (22a) de localisation du défaut, des composantes modales des ondes progressives détectées, dans lequel au moins deux des composantes modales ont, le long de la ligne (20), des vitesses de propagation différentes, et
- on détermine une distance entre le premier point (21a) de mesure et l'emplacement (23) du défaut, en utilisant les instants où les composantes modales atteignent le premier point (21a) de mesure.

2. Procédé suivant la revendication 1,
**caractérisé en ce qu'**

- on forme une différence entre les instants où les composantes modales atteignent le premier point (21a) de mesure ; et
- on détermine la distance entre le premier point (21a) de mesure et l'emplacement (23) du défaut en utilisant la différence ainsi que la vitesse de propagation des composantes modales respectives.

3. Procédé suivant la revendication 2,
**caractérisé en ce qu'**

- on détermine, par le calcul, la vitesse de propagation des composantes modales respectives.

4. Procédé suivant la revendication 2,
**caractérisé en ce qu'**

- on détermine, par une mesure, la vitesse de propagation des composantes modales respectives, en décomposant les ondes progressives se créant, dans l'état sans défaut, pendant une opération de coupure unipolaire sur la ligne (20), en des composantes modales et en déterminant les instants où les composantes modales respectives atteignent le premier point (21a) de mesure.

**5.** Procédé suivant la revendication 4,
**caractérisé en ce qu'**

- on effectue, de manière répétée, la mesure de la vitesse de propagation des composantes modales respectives.

**6.** Procédé suivant l'une des revendications précédentes,
**caractérisé en ce qu'**

- à partir des valeurs de mesure respectives des divers courants de phase, on forme les composantes modales au moyen d'une transformation, reposant sur des valeurs propres, de séparation de composantes modales.

**7.** Procédé suivant l'une des revendications précédentes,
**caractérisé en ce qu'**

- on filtre les valeurs de mesure de courant au moyen d'un filtre passe bande, dans lequel le filtre passe bande est réglé sur un domaine de fréquence, dans lequel les composantes modales ont respectivement une vitesse de propagation constante.

**8.** Procédé suivant l'une des revendications précédentes,
**caractérisé en ce qu'**

- on détecte les ondes progressives partant de l'emplacement (23) du défaut également en un deuxième point (21b) de mesure de la ligne ;
- on détermine, en utilisant les composantes modales, des ondes progressives détectées au deuxième point (21b) de mesure, une distance entre le deuxième point (21b) de mesure et l'emplacement (23) du défaut ; et
- on contrôle, si la somme de la distance entre le premier point (21a) de mesure et l'emplacement (23) du défaut et de la distance entre le deuxième point (21b) de mesure et l'emplacement (23) du défaut, correspond à la longueur de la ligne (20) entre les deux points (21a,b) de mesure.

**9.** Procédé suivant l'une des revendications 1 à 7 précédentes,
**caractérisé en ce qu'**

- on détecte les ondes progressives partant de l'emplacement (23) du défaut également en un deuxième point (21b) de mesure de la ligne ;
- s'il y a un défaut symétrique ou s'il y a un défaut sans contact à la terre au premier et au deuxième point de mesure, on détermine les instants de l'arrivée de fronts d'onde respectifs des ondes progressives respectives ;
- on forme des différences entre les instants d'une part du front d'onde arrivant en premier et d'autre part d'une pluralité d'autres fronts d'onde ;
- on forme pour le premier et le deuxième point (21a,b) de mesure, en utilisant les différences, une suite d'emplacements potentiels du défaut ; et
- on choisit l'emplacement du défaut, dans la suite d'emplacements potentiels du défaut, comme emplacement (23) réel du défaut, pour lequel la somme de la distance entre le premier point (21a) de mesure et l'emplacement du défaut choisi et de la distance entre le deuxième point (21b) de mesure et l'emplacement (23) du défaut choisi correspond à la longueur de la ligne (20) entre les deux points (21a,b) de mesure.

**10.** Dispositif (22a) de localisation d'un défaut pour la détermination d'un emplacement (23) d'un défaut sur une ligne (20) triphasée d'un réseau d'alimentation en énergie électrique, dans lequel le dispositif (22a) de localisation du défaut est agencé pour relever des premières valeurs de mesure de courant, qui indiquent respectivement des courants de phase passant dans la ligne (20) en un premier point (21a) de mesure et dans lequel le dispositif (22a) de localisation d'un défaut est agencé pour, en utilisant les premières valeurs de mesure de courant, détecter, lors d'un défaut, des ondes progressives se propageant le long de la ligne (20) de l'emplacement du défaut au premier point (21a) de mesure, et pour analyser les ondes progressives détectées pour la détermination de l'emplacement (23) de défaut ;
**caractérisé en ce que**

- le dispositif (22a) de localisation d'un défaut est agencé pour déterminer des composantes modales des ondes progressives détectées, dans lequel au moins deux des composantes modales ont des vitesses de propagation différentes le long de la ligne (20), et on détermine une distance entre le premier point (21a) de mesure et l'emplacement (23) du défaut, en utilisant les instants où les composantes modales atteignent le premier point (21a) de mesure.

**11.** Système comprenant au moins deux dispositifs de localisation d'un défaut, qui sont constitués suivant la revendication 10,
**caractérisé en ce que**

- le système est agencé pour détecter des ondes progressives partant de l'emplacement (23) du défaut également en un deuxième point (21b) de mesure de la ligne (20) et pour, en utilisant les composantes modales des ondes progressives détectées au deuxième point (21b) de mesure, déterminer une distance entre le deuxième point (21b) de mesure et l'emplacement (23) du défaut ; et
- le système est agencé pour contrôler, si la somme de la distance entre le premier point (21a) de mesure et l'emplacement (23) du défaut et de la distance entre le deuxième point (21b) de mesure et l'emplacement (23) du défaut correspond à la longueur de la ligne (20) entre les deux points (21a,b) de mesure.

**12.** Système comprenant au moins deux dispositifs de localisation d'un défaut, qui sont constitués suivant la revendication 10,
**caractérisé en ce que**

- le système est agencé pour détecter des ondes progressives partant de l'emplacement (23) du défaut également en un deuxième point (21b) de mesure de la ligne (20) ;
- le système est agencé pour déterminer, lors d'un défaut symétrique ou lors d'un défaut sans contact à la terre au premier et au deuxième point de mesure, les instants de l'arrivée de fronts d'onde respectifs des ondes progressives respectives ;
- le système est agencé pour former des différences entre les instants d'une part du front d'onde arrivant en premier et d'autre part d'une pluralité d'autres fronts d'onde ;
- le système est agencé pour former, pour le premier et le deuxième point (21a,b) de mesure en utilisant les différentes, une suite d'emplacements potentiels du défaut ; et
- le système est agencé pour choisir, comme emplacement (23) réel du défaut, l'emplacement d'un défaut parmi la suite d'emplacements potentiels du défaut, pour lequel la somme de la distance entre le premier point (21a) de mesure et l'emplacement du défaut choisi et de la distance entre le deuxième point (21b) de mesure et l'emplacement (23) du défaut choisi correspond à la longueur de la ligne (20) entre les deux points (21a,b) de mesure.

## FIG 1
(Stand der Technik)

## FIG 2

# FIG 3

EP 3 719 510 B1

FIG 4

FIG 5

FIG 6

FIG 7

# FIG 8

$\Delta t_{A(\alpha,\beta,0)}$

$\alpha,\beta$

0

Abtastwert mit $T_S = 10\,MHz$

x10$^5$

$\Delta t_{B(\alpha,\beta,0)}$

$\alpha,\beta$

0

Abtastwert mit $T_S = 10\,MHz$

x10$^5$

EP 3 719 510 B1

FIG 9

EP 3 719 510 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 2476002 B1
- WO 2012126526 A1
- US 4996624 A
- US 5929642 A
- US 8655609 B2
- WO 2016118584 A1
- EP 3351949 A1
- EP 3193420 A1